Europäisches Patentamt

European Patent Office

Office européen des brevets

(11) Publication number: **0 187 246**
A2

# EUROPEAN PATENT APPLICATION

(21) Application number: 85115078.9

(22) Date of filing: 27.11.85

(51) Int. Cl.⁴: **G 11 C 7/00**
**G 11 C 11/24**

(30) Priority: 28.12.84 JP 276152/84

(43) Date of publication of application:
16.07.86 Bulletin 86/29

(84) Designated Contracting States:
DE FR GB

(71) Applicant: Kabushiki Kaisha Toshiba
72, Horikawa-cho Saiwai-ku
Kawasaki-shi Kanagawa-ken 210(JP)

(72) Inventor: Saito, Shozo c/o Patent Division
Kabushiki Kaisha Toshiba 1-1 Shibaura 1-chome
Minato-ku Tokyo 105(JP)

(72) Inventor: Fujii, Syuso c/o Patent Division
Kabushiki Kaisha Toshiba 1-1 Shibaura 1-chome
Minato-ku Tokyo 105(JP)

(72) Inventor: Okada, Yoshio c/o Patent Division
Kabushiki Kaisha Toshiba 1-1 Shibaura 1-chome
Minato-ku Tokyo 105(JP)

(74) Representative: Henkel, Feiler, Hänzel & Partner
Möhlstrasse 37
D-8000 München 80(DE)

(54) Precharge circuit for bit lines of semiconductor memory.

(57) There is disclosed a precharge circuit of an intermediate
potential precharge type, for precharging the bit lines of a
semiconductor memory comprising transistor (N3) for short-
circuitting paired bit lines (BL, $\overline{BL}$) of a memory cell array
when precharge period starts, and transistors (N4, N5) for
applying 1/2 potential of a power source potential (Vcc) to the
paired bit lines during the precharge period.

F I G. 3

EP 0 187 246 A2

- 1 -

Precharge circuit for bit lines of
semiconductor memory

This invention relates to a circuit of an intermediate potential precharge type for precharging the bit
lines of a dynamic semiconductor memory.

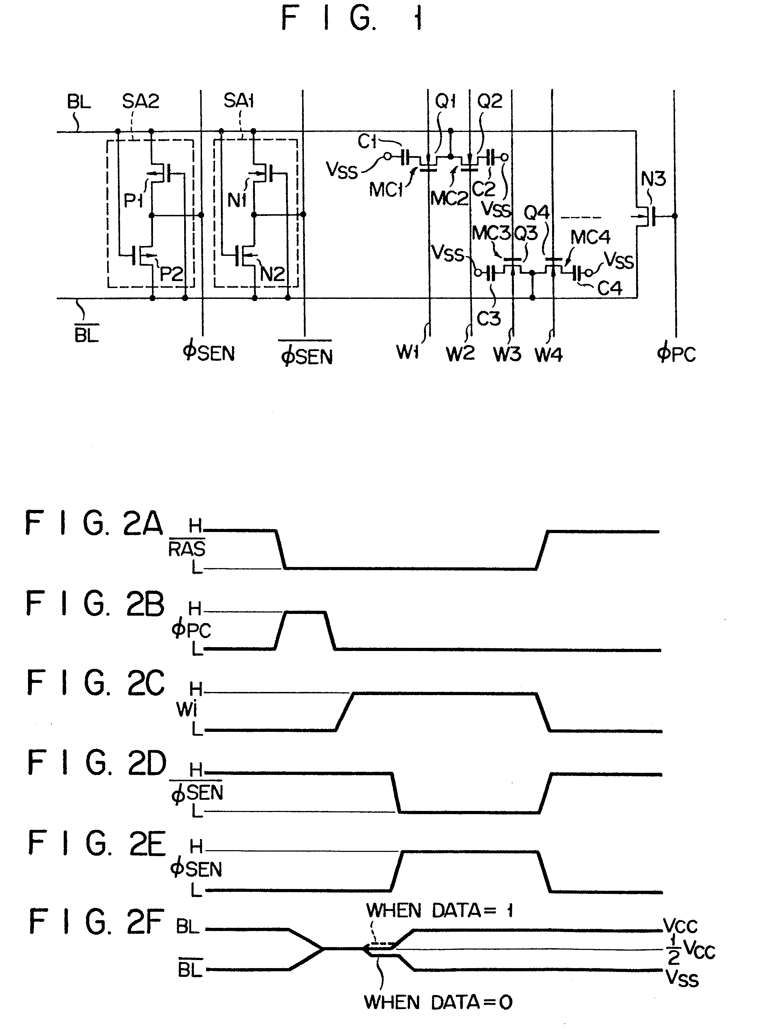

A precharge citcuit of this type is disclosed in
DIGEST OF TECHNICAL PAPERS OF ISSCC, page 106, "A 128K
Word × 8b DRAM," and page 276, "A 288Kb CMOS Pseudo
SRAM." The circuit precharges the bit lines of a memory
to 1/2 of a power source potential Vcc before a sense
operation is started. Another precharge circuit of the
same type is shown in Fig. 1, which is used in a dynamic
semiconductor memory.

This circuit comprises N channel MOS (metal oxide
semiconductor) transistor N3. A pair of bit lines BL
and $\overline{BL}$ cross over word lines Wl, W2, W3 and W4. Memory
cell MC1 comprises N channel MOS (metal oxide semicon-
ductor) transistor Ql and capacitor Cl serially connected to transistor Ql. Memory cell MC2 comprises N
channel MOS transistor Q2 and capacitor C2 serially connected to transistor Q2. Memory cell MC3 comprises N
channel MOS transnstor Q3 and capacitor C3 serially connected to transistor Q3. Memory cell MC4 comprises N
channel MOS transistor Q4 and capacitor C4 serially connected to transistor Q4. Word line Wl is connected to
the gate of transistor Ql. Word line W2 is connected to
the gate of transistor Q2. Word line W3 is connected to the gate of transistor Q3.  Word line W4 is connected to the gate of transistor Q4.  Transistor Q1 has two output electrodes connected to one terminal of capacitor C1 and one output electrode of transistor Q2.  The other output electrode of transistor Q2 is connected to one terminal of capacitor C2.  The node of transistors Q1 and Q2 is connected to bit line BL.  The other terminal of capacitor C1 is connected to ground or reference potential Vss.  The other terminal of capacitor C2 is also connected to ground.  Transistor Q3 has two output electrodes connected to one terminal of capacitor C3 and one output electrode of transistor Q4.  The other output electrode of transistor Q4 is connected to one terminal of capacitor C4.  The node of transistors Q3 and Q4 is connected to bit line $\overline{BL}$.  The other terminal of capacitor C3 is connected to ground or reference potential. The other terminal of capacitor C4 is also connected to ground or reference potential.

Sense amplifier SA1 are provided between bit lines BL and $\overline{BL}$.  Sense amplifier SA1 comprises N channel type MOS transistors N1 and N2 serially connected between bit lines  BL and $\overline{BL}$.  The gate of transistor N1 is connected to bit line $\overline{BL}$.  The gate of transistor N2 is connected to bit line BL.  The node of transistors N1 and N2 is supplied with an enable signal $\overline{\phi sen}$ (Fig. 2D) for enabling sense amplifier SA1.  Sense amplifier SA2 are provided between bit lines BL and $\overline{BL}$.  Sense amplifier SA2 comprises P channel type MOS transistors P1 and P2 serially connected between bit lines BL and $\overline{BL}$.  The gate of transistor P1 is connected to bit line $\overline{BL}$.  The gate of transistor P2 is connected to bit line BL.  The node of transistors P1 and P2 is supplied with an enable signal $\phi sen$ (Fig. 2E) for enabling sense amplifier SA2.  Sense amplifier SA2 functions as an active restoring circuit.  N channel MOS transistor N3 is connected between bit lines BL and $\overline{BL}$.  Transistor N3 is provided for precharging bit lines BL and $\overline{BL}$ to a

potential intermediate between the reference potential Vss and a power source potential Vcc higher than Vss. The gate of transistor N3 is supplied with a precharge. signal φpc.

When row address strobe signal $\overline{RAS}$ (Fig. 2A) is at a high level (precharge period), one of bit lines BL and $\overline{BL}$, for example, line BL is at Vcc potential and the other bit line $\overline{BL}$ is at Vss potential. Assume now that row address strobe signal $\overline{RAS}$ is changed to L or low level. Then, precharge signal φpc is changed to H or high level, thus turning transistor N3 on. Therefore, bit lines BL and $\overline{BL}$ are short-circuited and precharged to 1/2 Vcc potential. After precharge signal φpc (Fig. 2B) has been changed to L or a low level, a word line Wi (i=1, 2, 3, ...) (Fig. 2C), for example, W1, is selected by input address signal and rendered high. The data stored in memory cell MC1 connected to word line W1 is, therefore, read out on bit line BL. At the same time, dummy word line (not shown) is selected and rendered high, and the data stored in memory dummy cell (not shown) connected to the dummy word line (not shown) is read out on bit line $\overline{BL}$. The potential on bit line $\overline{BL}$ is at this time 1/2 Vcc potential. While, the potential on bit line BL is at this time several tens mV higher or lower than reference potential according whether data read out of selected cell MC1 Vcc is 1 or 0. Therefore, a little difference of voltage appear between bit lines BL and $\overline{BL}$. Thereafter, enable signal φsen is rendered low (enable signal φsen is rendered high), amplifying the voltage difference between bit lines BL and $\overline{BL}$. As a result, the potential on bit line BL is Vcc potential, and the potential on bit line $\overline{BL}$ is Vss potential.

With the conventional precharge circuit, however, a relatively long period elpases from the time precharge signal φpc becomes a high level to the time bit lines BL, $\overline{BL}$ becomes a 1/2 Vcc potential. Hence, the access time to the memory is relatively long.

This invention has been accomplished under the above mentioned circumstances and the object is to provide a precharge circuit for bit lines of a semiconductor memory in which an access time is shortened and a sense operation is stable even when a precharge period is long.

According to the invention, there is provided a precharge circuit for bit lines of a semiconductor memory comprising: circuit means for short-circuiting paired bit lines of a memory cell array of a semiconductor memory when a precharge period starts, and circuit means for applying a 1/2 potential of a power source potential to said paired bit lines during said precharge period.

This invention can be more fully understood from the following detailed description when taken in conjunction with the accompanying drawings, in which:

Fig. 1 shows a circuit diagram of a conventional precharge circuit combined with a semiconductor memory;

Figs. 2A to 2F show time charts of signals at various portions of the Fig. 2 circuit, respectively;

Fig. 3 shows a circuit diagram of a precharge circuit combined with a semiconductor memory, according to an embodiment of the invention; and

Figs. 4A to 4F show time charts of signals at various portions of the Fig. 4 circuit, respectively.

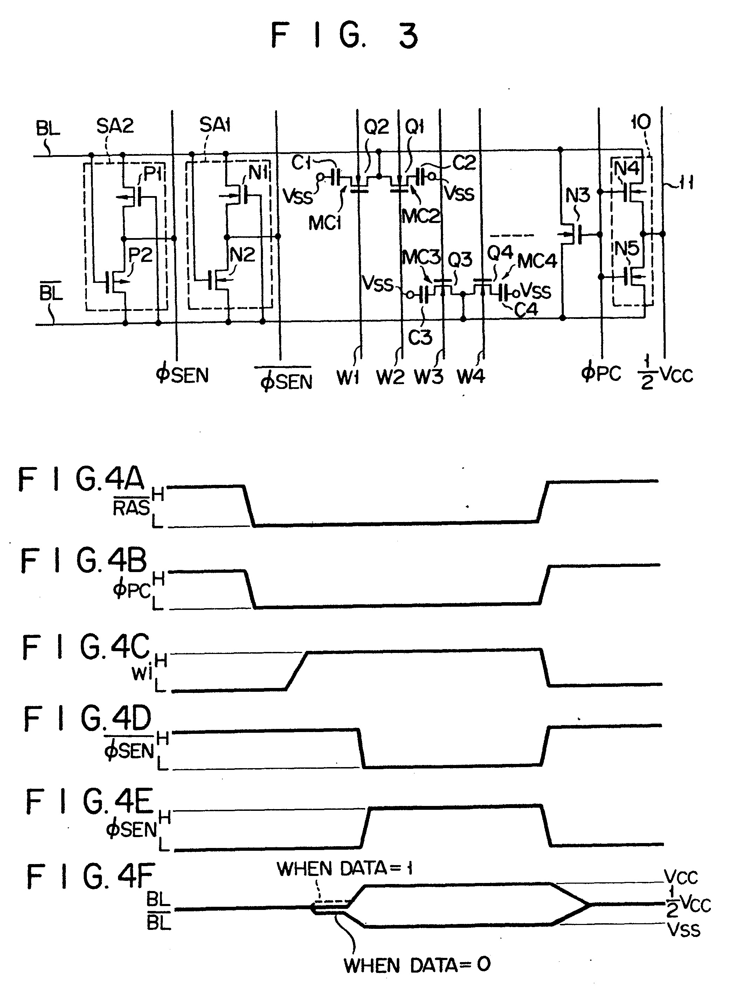

In the dynamic type memory device shown in Fig. 3 to which a precharge circuit, of an intermediate potential precharge type, according to an embodiment of the invention is applied, a pair of bit lines BL and $\overline{BL}$ cross over word lines W1, W2, W3 and W4. Only four word lines are shown in the drawing for brevity. More word lines may actually be provided. Memory cell MC1 comprises N channel MOS (metal oxide semiconductor) transistor Q1 and capacitor C1 serially connected to transistor Q1. Memory cell MC2 comprises N channel MOS transistor Q2 and capacitor C2 serially connected to transistor Q2. Memory cell MC3 comprises N channel MOS transistor Q3 and capacitor C3 serially connected to transistor Q3. Memory cell MC4 comprises N channel MOS transistor Q4 and capacitor C4 serially connected to transistor Q4. Word line W1 is connected to the gate of transistor Q1. Word line W2 is connected to the gate of transistor Q2. Word line W3 is connected to the gate of transistor Q3. Word line W4 is connected to the gate of transistor Q4. Transistor Q1 has two output electrodes connected to one terminal of capacitor C1 and one output electrode of transistor Q2. The other output electrode of transistor Q2 is connected to one terminal of capacitor C2. The node of transistors Q1 and Q2 is connected to bit line BL. The other terminal of capacitor C1 is connected to ground level Vss or a cell plate potential. The other terminal of capacitor C2 is also connected to ground level Vss or a cell plate potential. Transistor Q3 has two output electrodes connected to one terminal of capacitor C3 and one output electrode of transistor Q4. The other output electrode of transistor Q4 is connected to one terminal of capacitor C4. The node transistors FQ3 and Q4 is connected to bit line $\overline{BL}$. The other terminal of capacitor C3 is connected to ground level Vss or a cell plate potential. The other terminal of capacitor C4 is also connected to ground level Vss or a cell plate potential Vss.

Sense amplifier SA1 are provided between bit lines BL and $\overline{BL}$. Sense amplifier SA1 comprises N channel type MOS transistors N1 and N2 serially connected between bit lines BL and $\overline{BL}$. The gate of transistor N1 is connected to bit line $\overline{BL}$. The gate of transistor N2 is connected to bit line BL. The node of transistors N1 and N2 is supplied with an enable signal $\overline{\phi sen}$ (Fig. 4D) for enabling sense amplifier SA1. Sense amplifier SA2 are provided between bit lines BL and $\overline{BL}$. Sense amplifier SA2 comprises P channel type MOS transistors P1 and P2 serially connected between bit lines BL and $\overline{BL}$. The gate of transistor P1 is connected to bit line $\overline{BL}$. The gate of transistor P2 is connected to bit line BL. The node of transistors P1 and P2 is supplied with an enable signal $\phi$sen (Fig. 4E) for enabling sense amplifier SA2. Sense amplifier SA2 functions as an active restoring circuit. N channel MOS transistor N3 is connected between bit lines BL and $\overline{BL}$. Transistor N3 is provided for precharging bit lines BL and $\overline{BL}$ to a potential intermediate between the reference potential Vss and a power source potential Vcc higher than Vss. The gate of transistor N3 is supplied with a precharge signal $\phi$pc (Fig. 4B).

Intermediate applying circuit 10 is provided between bit lines BL and $\overline{BL}$. Applying circuit 10 comprises N channel type MOS transistors N4 and N5 serially connected between bit lines BL and $\overline{BL}$. The gate of transistors N4 and N5 are supplied with precharge signal $\phi$pc (Fig. 4B). The node of transistors N4 and N5 is supplied with an intermediate potential of a power source potential Vcc, i.e., 1/2 Vcc potential, through line 11. 1/2 Vcc potential is supplied from a 1/2 Vcc potential generator (not shown) for generating 1/2 Vcc potential. Transistors N4 and N5 are rendered on when precharge pulse $\phi$pc is at high and rendered off when precharge pulse $\phi$pc is at low.

When row address strobe signal $\overline{RAS}$ (Fig. 4A) is at a high level, one of bit lines BL and $\overline{BL}$, for example, line BL is at Vcc potential and the other bit line $\overline{BL}$ is at Vss potential. When row address strobe signal $\overline{RAS}$ is at H or a high level, precharge signal $\phi$pc is also at a high level. Assume now that row address strobe signal $\overline{RAS}$ is changed to L or a low level. Then, precharge signal $\phi$pc is also changed to L or a low level, thus turning transistor N3 off. Thereafter, a word line Wi (i=1, 2, 3, ...) (Fig. 4C), for example, W1, is selected by input address signal and rendered high. The data stored in memory cell MC1 connected to word line W1 is, therefore, read out on bit line BL. At the same time, dummy word line (not shown) is selected and rendered high, and the data stored in memory dummy cell (not shown) connected to dummy word line (not shown) is read out on bit line $\overline{BL}$. The potential on bit line $\overline{BL}$ is at this time 1/2 Vcc potential. While, the potential on bit line BL is at this time several tens mV higher or lower than reference potential according whether data read out of selected cell MC1 Vcc is 1 or 0. Therefore, a little difference of voltage appear between bit lines BL and $\overline{BL}$. Thereafter, enable signal $\phi$sen is rendered low (enable signal $\phi$sen is rendered high), amplifying the voltage difference between bit lines BL and $\overline{BL}$. As a result, the potential on bit line BL is Vcc potential, and the potential on bit line $\overline{BL}$ is Vss potential. Thereafter, $\overline{RAS}$ signal is changed to a high level. At the same time precharge signal $\phi$pc is also changed to a high level, thereby turning transistors N3, N4 and N5 on. Since transistor N3 is turned on so that bit lines BL and $\overline{BL}$ are short-circuited. Also since transistors N4 and N5 are turned on so that bit lines BL and $\overline{BL}$ are connected to 1/2 Vcc potential through transistors N4 and N5, respectively, and precharged to 1/2 Vcc potential.

As described above, with the precharge circuit of this embodiment, when $\overline{RAS}$ signal is changed to a high level, precharge signal $\phi$pc is also changed to a high level, thereby turning transistors N3, N4 and N5 on, so that bit lines BL and $\overline{BL}$ are short-circuited and connected to 1/2 Vcc potential. Therefore, no leak current through a memory cell will occur and a potential on bit lines BL and $\overline{BL}$ is not lowered, even when the precharge period is long. This makes the sense operation stable. Furthermore, since bit lines BL and $\overline{BL}$ are precharged when an active period starts, the access time is shorted.

0187246

This invention is not limited to the embodiment mentioned above. N channel MOS transistors Q1 to Q4 may be replaced by P channel MOS transistors. Precharging N channel MOS transistors N3 to N5 may also be replaced by P channel MOS transistors.

As clearly understood from the above, with a precharge circuit of the invention, the access time can be shortened, and the sense operation can be stable even when a precharge period is long.

Claims:

1.  A precharge circuit for bit lines of a semiconductor memory characterized by comprising:
    circuit means (N3) for short-circuiting paired bit lines (BL, $\overline{BL}$) of a memory cell array of a semiconductor memory when a precharge period starts; and
    circuit means (N4, N5) for applying a 1/2 potential of a power source potential (Vcc) to said paired bit lines during said precharge period.

2.  A precharge circuit according to claim 1, characterized in that said short-circuiting circuit means (N3) comprises an MOS transistor (N3) whose drain source path is connected between said paired bit lines and whose gate is connected to a precharge signal for said paired bit lines.

3.  A precharge circuit according to claim 1, characterized in that said potential applying circuit means (N4, N5) comprises first and second MOS transistors (N4, N5) whose drain source paths are connected in series between said paired bit lines and whose gates are connected to a precharge signal for said paired bit lines, the junction of said drain source paths of said first and second MOS transistors being to connected said 1/2 potential.

F I G. 1

0187246

F I G. 2A  $\overline{RAS}$

F I G. 2B  $\phi PC$

F I G. 2C  $Wi$

F I G. 2D  $\overline{\phi SEN}$

F I G. 2E  $\phi SEN$

F I G. 2F

WHEN DATA = 1

WHEN DATA = 0

$V_{CC}$
$\frac{1}{2}V_{CC}$
$V_{SS}$

0187246

# FIG. 3

FIG. 4A $\overline{RAS}$

FIG. 4B $\phi PC$

FIG. 4C $wi$

FIG. 4D $\overline{\phi SEN}$

FIG. 4E $\phi SEN$

FIG. 4F

WHEN DATA = 1

$BL$
$\overline{BL}$

$Vcc$
$\frac{1}{2}Vcc$
$Vss$

WHEN DATA = 0